Europäisches Patentamt

European Patent Office

Office européen des brevets

(19)

(11) Numéro de publication: **0 042 326**
**A1**

# (12) DEMANDE DE BREVET EUROPEEN

(21) Numéro de dépôt: 81400911.4

(22) Date de dépôt: 09.06.81

(51) Int. Cl.³: **H 01 L 31/02, H 01 L 31/10**

(30) Priorité: 13.06.80 FR 8013187

(43) Date de publication de la demande: 23.12.81
Bulletin 81/51

(84) Etats contractants désignés: **DE GB NL**

(71) Demandeur: **SOCIETE ANONYME DE TELECOMMUNICATIONS, 40 avenue de New York, F-75116 Paris (FR)**

(72) Inventeur: **Gauthier, André, 170 rue Nationale, F-75013 Paris (FR)**

(74) Mandataire: **Bloch, Robert et al, 39 avenue de Friedland, F-75008 Paris (FR)**

(54) Photodétecteur rapide de grande surface sensible dans la gamme 0,8 - 1,1 micro-m.

(57) Photodétecteur de grande surface sensible dans la gamme 0,8–1,1 μm, comportant un substrat (1) et une couche de diffusion (2) définissant une jonction PN, et des contacts (4, 5, 6) pour l'application d'une tension de polarisation.

Le substrat est en silicium de résistivité supérieure à $10^3$ Ω.cm et un filtre (7) arrêtant les rayonnements de longueur d'onde inférieure à 0,8 μm, constitué de préférence par une couche de CdTe, est placé sur la face proche de la jonction, exposée au rayonnement.

EP 0 042 326 A1

## Photodétecteur rapide de grande surface sensible dans la gamme 0,8 - 1,1 $\mu$m.

La présente invention concerne un photodétecteur infrarouge sensible aux longueurs d'onde dans la gamme de 0,8 à 1,1 $\mu$m, et doté d'un temps de réponse très court.

Dans le domaine spectral considéré, au voisinage de 1 $\mu$m, plusieurs types de photodétecteurs peuvent être envisagés.

Les photoconducteurs (par exemple PbS, $Tl_2S$) ont toujours des temps de réponse supérieurs à la microseconde et ne peuvent être considérés comme des détecteurs rapides.

Certains photomultiplicateurs ont des performances très satisfaisantes. Par exemple, les photocathodes du type $InAs_{0,85}P_{0,15}OCs$ ou $Ga_{1-x}In_xAsOCs$ possèdent un rendement quantique très satisfaisant au voisinage de 1 $\mu$m et un temps de montée très faible, de l'ordre de la nanoseconde. Mais ils présentent de sérieux inconvénients pratiques : fragilité, complexité de réalisation, nécessité d'une tension de polarisation élevée, ce qui rend leur emploi peu commode et leur prix élevé.

Enfin, dans le cas des détecteurs photovoltaïques, plusieurs matériaux peuvent être envisagés : Ge, Si, InAs, InSb, $Hg_{1-x}Cd_x$ Te.

On connaît également, notamment par le brevet français 1 561 967, un photodétecteur photovoltaïque, de grande surface, sensible dans la gamme 0,8 - 1,1 $\mu$m, comportant un substrat en silicium de résistivité supérieure à $10^3 \Omega$.cm, une couche de diffusion définissant une jonction PN, un filtre placé sur la face, proche de la jonction, exposée aux rayonnements pour arrêter les rayonnements de longueur d'onde inférieure à une longueur déterminée, et des contacts pour l'application d'une tension de polarisation.

Plus particulièrement, le détecteur du brevet ci-dessus présente un maximum de sensibilité situé vers 1,06 μm.

Le silicium étant sensible à partir d'une longueur d'onde d'environ 0,4 μm, la présence d'un filtre passe-haut déterminé permet assurément de restreindre la bande spectrale du détecteur.

Certes, grâce à la résistivité élevée du substrat en silicium, le courant de fuite est faible et sensiblement constant sur une large plage de polarisation. On peut donc appliquer une tension de polarisation inverse élevée, afin de décaler la longueur d'onde de coupure du silicium et de réduire la capacité de jonction et par conséquent le temps de réponse.

Toutefois, le détecteur décrit ci-dessus n'est pas approprié pour la détection du rayonnement des diodes AsGa émettant à 0,95 μm, utilisées dans les systèmes de télécommunications optiques.

La présente invention vise donc à résoudre un tel problème.

A cet effet, elle concerne un photodétecteur photovoltaïque, de grande surface, sensible dans la gamme 0,8 - 1,1 μm, comportant un substrat en silicium de résistivité supérieure à $10^3 \Omega.cm$, une couche de diffusion définissant une jonction PN, un filtre, placé sur la face, proche de la jonction, exposée aux rayonnements pour arrêter les rayonnements de longueur d'onde inférieure à une longueur déterminée, et des contacts pour l'application d'une tension de polarisation, caractérisé par le fait que le filtre est une couche de CdTe intégrée au détecteur et arrêtant les rayonnements de longueur d'onde inférieure à 0,8 μm.

Grâce au filtre de l'invention, on obtient une réponse spectrale très "pointue" centrée sur 0,95 μm. Le détecteur est ainsi à l'abri des rayonnements parasites, le courant d'obscurité est réduit et par suite la sensibilité du détecteur est excellente.

L'invention sera bien comprise à la lecture de la description ci-après, faite en référence aux dessins annexés.

- la fig. 1 illustre les différentes phases de la fabrication du détecteur selon l'invention;

- la fig. 2 représente la réponse spectrale du détecteur selon l'invention.

Pour la fabrication du détecteur selon l'invention, on part d'un monocristal de silicium 1 (fig. 1A). Le silicium est de type P faiblement dopé au bore, le dopage faible ayant pour effet une résistivité élevée d'environ $10^4$ $\Omega$.cm.

Ce monocristal 1 subit un traitement de polissage mécanique et chimique.

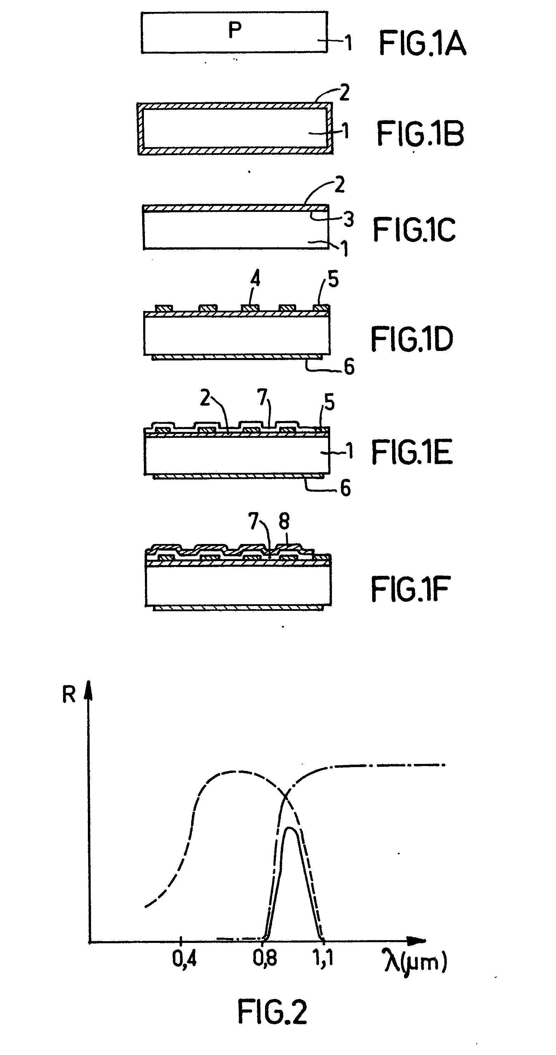

On procède ensuite à la diffusion d'impuretés de type N, en l'espèce le phosphore. La couche de diffusion 2 (fig.1B) a une épaisseur inférieure à 1 μm.

On masque la face destinée à recevoir le rayonnement et on effectue une attaque chimique, puis on supprime la couche de masquage. On a ainsi obtenu une jonction PN 3 (fig. 1C).

On réalise ensuite les contacts par évaporation sous vide par exemple de titane et d'argent (fig. 1D). Les contacts 4 et le contact d'extrémité 5 de la face exposée au rayonnement sont en forme de peigne afin de représenter la surface minimale, tandis que la face opposée porte un contact plein 6.

On masque le contact d'extrémité 5, et on dépose sur la face exposée au rayonnement une couche de CdTe 7 (fig. 1E) d'une épaisseur comprise entre 1 et 10 $\mu$m, par exemple de 5 $\mu$m. Ce dépôt est effectué par une technique telle que l'évaporation thermique ou la pulvérisation cathodique.

Puis on dépose par dessus la couche de CdTe une couche antireflets 8 en oxyde, par exemple en $SiO_2$ ou $TiO_2$, afin de diminuer les pertes par réflexion dans le domaine spectral utile, entre 0,8 et 1,1 $\mu$m, et ainsi d'améliorer la réponse spectrale.

Le masque du contact 5 est enfin retiré. Le détecteur terminé est représenté à la fig. 1F.

Lors de l'emploi, on applique une tension de polarisation inverse de -10V. La réponse spectrale du détecteur est illustrée par la fig. 2.

Sur la fig. 2, la couche en tirets représente la réponse spectrale du détecteur au silicium représenté à la fig. 1D, soumis à une polarisation inverse de -10V. La bande spectrale se situe entre 0,4 $\mu$m et 1,1 $\mu$m, c'est-à-dire couvre tout le visible et l'infrarouge très proche.

La courbe en trait mixte représente la réponse spectrale de CdTe. Ce matériau est opaque aux rayonnements de longueur d'onde inférieure à 0,8 $\mu$m, et sa transparence augmente très rapidement de 0,8 à 0,9 $\mu$m et atteint son maximum à partir de 1 $\mu$m. La couche de CdTe se comporte ainsi comme un filtre passe-haut dont la valeur de coupure est 0,8 $\mu$m.

La couche en trait plein représente la réponse spectrale du détecteur de la fig. 1E muni de la couche de CdTe. Cette courbe résulte du produit des deux courbes précédentes, et l'on constate que le domaine spectral se situe entre 0,8 et 1,1 $\mu$m, avec un maximum très accusé à 0,95 $\mu$m.

Le détecteur selon l'invention aura donc une excellente sensibilité vis-à-vis des rayonnements à 0,95 $\mu$m tels que ceux émis par les diodes AsGa.

Les caractéristiques du détecteur, dans l'exemple décrit sont les suivantes :

| | |
|---|---|
| surface sensible | 2cm$^2$ |
| courant d'obscurité | $<$ 0,5 $\mu$A |
| responsivité pour $\lambda$ = 0,95 $\mu$m | $>$ 0,7 A/W |
| temps de réponse | $<$ 10 ns |

Le détecteur selon l'invention présente un ensemble de propriétés très avantageuses : grande surface, excellente sensibilité pour $\lambda$ = 0,95 $\mu$m, temps de réponse très court, et d'autre part, le matériau du substrat étant le silicium, faible prix du matériau et facilité d'emploi, le détecteur pouvant fonctionner à la température ordinaire.

Revendication.

Photodétecteur photovoltaïque, de grande surface, sensible dans la gamme 0,8 - 1,1 μm, comportant un substrat en silicium de résistivité supérieure à $10^3$ Ω.cm, une couche de diffusion définissant une jonction PN, un filtre placé sur la face, proche de la jonction, exposée aux rayonnements pour arrêter les rayonnements de longueur d'onde inférieure à une longueur déterminée, et des contacts pour l'application d'une tension de polarisation, caractérisé par le fait que le filtre est une couche de CdTe intégrée au détecteur et arrêtant les rayonnements de longueur d'onde inférieure à 0,8 μm.

0042326

1/1

P ⌐1  FIG.1A

2

1  FIG.1B

2
3
1  FIG.1C

4    5

6  FIG.1D

2    7    5

1  FIG.1E

6

7  8

FIG.1F

R

0,4    0,8  1,1    λ(μm)

FIG.2

Office européen
des brevets

**RAPPORT DE RECHERCHE EUROPEENNE**

0042326

Numéro de la demande

EP 81 42 0061

| Catégorie | Citation du document avec indication, en cas de besoin, des parties pertinentes | Revendica-tion concernée |
|---|---|---|
| D | <u>FR - A - 1 561 967</u> (RTC) <br> * Pages 3-5; figure 1 * | 1 |
| | <u>FR - A - 1 563 710</u> (RTC) <br> * En entier * | 1 |
| A | <u>FR - A - 2 362 412</u> (SIEMENS) <br> * Revendications * | 1 |

## DOCUMENTS CONSIDERES COMME PERTINENTS

**CLASSEMENT DE LA DEMANDE** (Int. Cl.³)

H 01 L 31/02
31/10

**DOMAINES TECHNIQUES RECHERCHES** (Int. Cl.³)

H 01 L 31/02
31/10

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

☒ Le présent rapport de recherche a été établi pour toutes les revendications

| Lieu de la recherche | Date d'achèvement de la recherche | Examinateur |
|---|---|---|
| La Haye | 18-09-1981 | ROUBERT |

OEB Form 1503.1  06.78